Europäisches Patentamt

European Patent Office

Office européen des brevets

(19)

(11) Veröffentlichungsnummer: **0 004 274**
**B1**

(12) **EUROPÄISCHE PATENTSCHRIFT**

(45) Veröffentlichungstag der Patentschrift: 23.06.82

(21) Anmeldenummer: 79100266.0

(22) Anmeldetag: 30.01.79

(51) Int. Cl.³: **H 03 K 19/082,**
**H 01 L 27/08**

(54) Grundschaltung einer integrierten Transistor-Logik sowie logische Schaltung unter Verwendung einer derartigen Grundschaltung.

(30) Priorität: 29.03.78 US 891240

(43) Veröffentlichungstag der Anmeldung:
03.10.79 Patentblatt 79/20

(45) Bekanntmachung des Hinweises auf die Patenterteilung:
23.06.82 Patentblatt 82/25

(84) Benannte Vertragsstaaten:
BE CH DE FR GB NL SE

(56) Entgegenhaltungen:
FR - A - 2 339 957

PATENTS ABSTRACTS OF JAPAN, Band 1, Nr. 77, 22. Juli 1977, Seite 1310E77
IBM TECHNICAL DISCLOSURE BULLETIN, Band 19, Nr. 6, November 1976, New York, USA, CHIN et al.: "MTL-compatible current switch circuit", Seiten 2081—2083
IBM TECHNICAL DISCLOSURE BULLETIN, Band 19, Nr. 11, April 1977, New York, USA, HELWIG et al.: "MTL-bootstrapped set-reset latch", Seiten 4199—4200

(73) Patentinhaber: International Business Machines Corporation
Armonk, N.Y. 10504 (US)

(72) Erfinder: Harris, James Herbert
Eight John Perry Drive
Danbury Connecticut 06810 (US)

(74) Vertreter: Gaugel, Heinz, Dipl.-Ing.
Schönaicher Strasse 220
D-7030 Böblingen (DE)

(56) Entgegenhaltungen:
IBM TECHNICAL DISCLOSURE BULLETIN, Band 19, Nr. 5, Oktober 1976, New York, USA, PRICER et al.: "Merged transistor logic circuit with majority-carrier current source", Seiten 1630—1631
WESCON TECHNICAL PAPERS, Band 19, Nr. 19/2, 1975, Hollywood, USA, BRUEDERLE et al.; "designing with I2L, Seiten 1—5

**Grundschaltung einer integrierten Transistor-Logik sowie logsche Schaltung unter Verwendung eines derartigen Grundschaltung**

Die Erfindung betrifft eine Grundschaltung einer integrierten Transistorlogik mit einer einen an eine erste Potentialquelle angeschlossenen gemeinsamen Kollektor, eine gemeinsame Basis und mehrere individuelle Emitter aufweisenden Transistorstruktur, die leitend ist, wenn ein von einem Injektor gelieferter Strom in die den Eingang die Grundschaltung bildende gemeinsame Basis injiziert wird, und die gesperrt ist, wenn dieser Strom in abhängigkeit von der Größe eines Eingangssignals von seiner Basis abgezweigt wird, und mit mindestens einem zweiten, invers betriebenen Transistor, dessen individuelle Emitter ein Ausgang der Grundschaltung ist, sowie eine logische Schaltung unter Verwendung einer derartigen Grundschaltung. Eine derartige Grundschaltung ist aus der Zeitschrift IBM—Technical Disclosure Bulletin, vol. 19, No. 6, November 1976, Seiten 2081—2083 bekannt.

Es ist bereits eine große Anzahl von logischen Schaltungsfamilien bekannt. In erster Linie sind zu nennen, die Stromübernahme-Emitterfolger-Logik, die Transistor-Transistor-Logik, die Dioden-Transistor-Logik, die Schottky-Dioden-Transistor-Logik und die integrierte Injektionslogik ($I^2L$), die auch unter dem Begriff "merged transistor logic" (MTL) bekannt ist. Jede dieser Schaltungsfamilien weist charakteristische, vorteilhafte Merkmale auf, die jedoch jeweils auch wieder von bestimmten nachteiligen Merkmalen bagleitet sind, Beispielsweise ist die Stromübernahme-Emitterfolger-Logik extrem schnell, der Leistungsbedarf ist jedoch relativ hoch. Ähnliches gilt für die Schottky-Dioden-Transistor-Logik, die zusätzlich den Nachteil aufweist, daß die Schottky-Dioden in speziellen Verfahrensschritten hergestellt werden müssen. Die Transistor-Transistor-Logik weist einen nur relativ geringen Leistungsbedarf auf, die Schaltgeschwindigkeit ist jedoch relativ gering, so daß diese Schaltungsfamilie vorzugsweise im Rahmen kleinerer elektronischer Rechnersysteme Verwendung findet. Die moderne integrierte injektionslogik bietet die Vorteile einer sehr hohen Packungsdichte, eines niedrigen Leitungsverbrauchs und einer relativ großen Ausgangs- und Eingangsfächerung. Der Nachteil dieser Logik liegt in der relativ niedrigen Schaltgeschwindigkeit, da ein invers betriebener NPN-Transistor verwendet werden muß und die Ladungsspeicherung aufgrund des bei hoher Sättigung leitenden NPN-Transistors relativ groß ist. Weiterhin ist festzustellen, daß die Halbleiterstruktur dieser Logik relativ empfindlich bezüglich kristalliner Fehler ist, die zu Kurzschlüssen oder Leckstromwegen führen können.

Es ist also festzustellen, daß keine der bekannten Schaltungsfamilien eine ideale Lösung für alle Anwendungsfälle darstellt. Hier will die Erfindung Abhilfe schaffen. Die Erfindung, wie sie in den Ansprüchen gekennzeichnet ist, löst die Aufgabe, eine Grundschaltung einer integrierten Transistor-Logik zu schaffen, die im Vergleich zu den bekannten Grundschaltungen in erhöhter Integrationsdichte mit verbesserten Eigenschaften und mit erhöhter Ausbeute herstellbar ist und gleichzeitig bei relativ geringem Leistungsbedarf eine hohe Eingangs- und Ausgangsfächerung zuläßt.

Die durch die Erfindung erreichten Vorteile sind im wesentlichen darin zu sehen, daß die Grundschaltung die vorteilhaften Merkmale der bekannten integrierten Injektionlogik aufweist, wobei jedoch gleichzeitig deren Nachteile vermieden sind.

Im folgenden wird die Erfindung anhand von ledigleich bevorzugte Ausführungsbeispiele darstellenden Zeichnungen näher erläutert.

Es zeigen:

Fig. 1 das Ersatzschaltbild einer erfindungsgemäßen Grundschaltung,

Fig. 2 die Draufsicht eines Ausführungsbeispiels der integrierten Struktur einer erfindungsgemäßen Grundschaltung und,

Fig. 3 das Schaltbild eines Ausführungsbeispiels einer logischen Schaltung, die unter Verwendung der erfindungsgemäßen Grundschaltung aufgebaut ist.

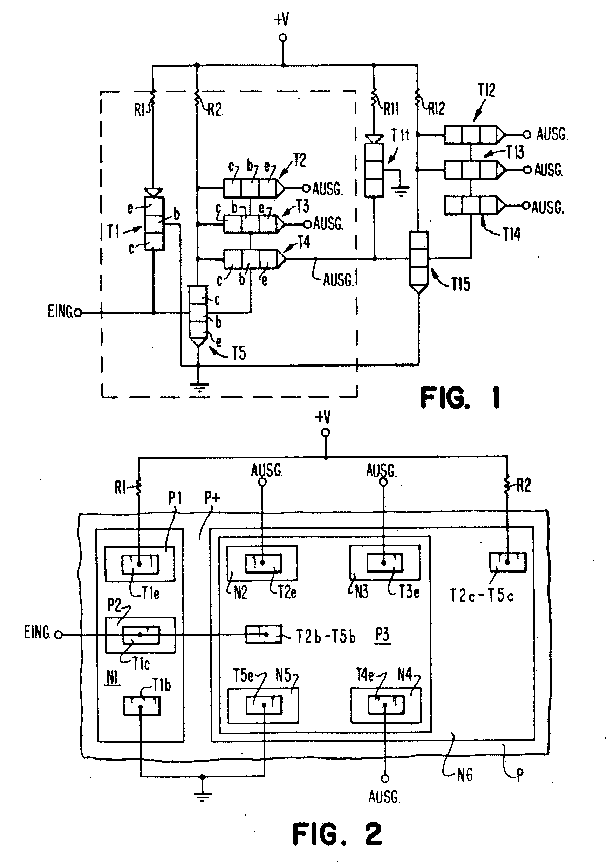

Die in Fig. 1 dargestellte erfindungsgemäße Grundschaltung einer integrierten Transistor-Logik umfaßt komplementäre, bipolare Transistoren, van denen einige invers betrieben werden. Ein lateraler PNP-Transistor T1 mit Emitter (e), Basis (b) und Kollektor (c) ist für die vorgesehene Strominjektion zuständig. Der Emitter T1e des Transistors T1 ist über einen Widerstand R1 mit einer ersten festen Potentialquelle +V verbunden. Die Basis T1b liegt an einer zweiten festen Potentialquelle, beispielsweise Masse. Der Kollektor T1c liegt am Eingangsknoten (EING) und gleichzeitig an der Basis T5b eines Transistors T5. Damit liefert der Transistor T1 ständig einen Strom entweder in die Basis T5b des Transistors T5 oder in den Eingangsknoten. Dem Transistor T5 wird der Strom zugeleitet, wenn am Eingangsknoten ein oberer Pegel anliegt. Liegt am Eingangsknoten ein unterer Pegel, so wird der Strom vom Transistor T5 weggeleitet.

Beim Transistor T5 handelt es sich um einen normal betriebenen NPN-Transistor, dessen Emitter T5e mit Masse und dessen Basis T5b mit den Basen weiterer Transistoren T2, T3 und T4 verbunden ist. Der Kollektor T5c ist mit den Kollektoren der Transistoren T2, T3 und T4 verbunden. Ein wahlweise vorsehbarer Widerstand R2 verbindet den von den Kollektoren T2c, T3c, T4c und T5c gebildeten, gemeinsamen Knoten mit der ersten Potentialquelle +V. Ist dieser Kollektorwiderstand R2 vorgesehen, so wird über ihn bei gesperrtem Transistor T5 der gemeinsame Kollektorknoten aufgeladen.

Die NPN-Transistoren T2, T3 und T4 sind invers betrieben und liefern an ihren Emittern T2e, T3e und T4e getrennte Ausgänge. Ein wesentlicher Vorteil der erfindungsgemäßen Schaltung besteht darin, daß jede gewünschte Ausgangsfächerung (mindestens zehn Ausgänge) erreichbar ist, ohne daß die Funktionstüchtigkeit der Schaltung dadurch beeinträchtigt würde. Einfachheitshalber ist im betrachteten Ausführungsbeispiel lediglich eine Ausgangsfächerung über drei Transistoren T2, T3 und T4 vorgesehen. Sind die Transistoren T2, T3 und T4 leitend, so gehen sie in Sättigung und verursachen keinen Spannungsabfall. D. h., daß der untere Ausgangspegel in der Nähe von Massepotential liegt. Diese Tatsache stellt gegenüber Diodenverbindungen, die immer einen Spannungsabfall in Durchlaßrichtung aufweisen, einen wesentlichen Vorteil dar. Die erfindungsgemäße Schaltung weist damit einen sehr hohen Störabstand auf und ist mit konventionellen Halbleiterprozessen herstellbar, die nicht Prozesse zur Bildung Schottky-Dioden umfassen.

Der innerhalb der gestrichelten Linien liegende Schaltungsteil stellt eine erfindungsgemäße Grundschaltung dar. Der restliche Schaltungsteil von Fig. 1 betrifft eine weitere erfindungsgemäße Grundschaltung innerhalb eines logischen Netzwerkes. D. h. also, daß die Widerstände R11 und R12 den Widerständen R1 und R2 entsprechen. Der laterale PNP-Transistor T11 entspricht dem Transistor T1, während der NPN-Transistor T15 dem Transistor T5 entspricht. Schließlich entsprechen die invers betriebenen NPN-Transistoren T12, T13 und T14 den bereits beschriebenen Transistoren T2, T3 und T4. Auch bei der zweiten in Fig. 1 dargestellten Grundschaltung ist beispielsweise eine dreifache Ausgangsfächerung vorgesehen, die im Prinzip beliebig erweiterbar ist. Selbstverständlich können die beiden zu verknüpfenden Grundschaltungen auch unterschiedliche Ausgangsfächerungen aufweisen.

In Fig. 2 ist die integrierte Halbleiterstruktur der innerhalb der gestrichelten Linie von Fig. 1 angeordneten erfindungsgemäßen Grundschaltung dargestellt. Der laterale PNP-Transistor T1 ist im linken Teil verwirklicht, während die NPN-Transistoren im rechten Teil der Anordnung liegen. Der ohmsche Emitteranschluß des Transistors T1 ist mit T1e bezeichnet und liegt in der hochdotierten Emitterzone P1. Der ohmsche Kollektoranschluß ist mit T1c bezeichnet und liegt in der hochdotierten Kollektorzone P2. Die aktive Basiszone des lateralen Transistors T1 ist das N1-Gebiet zwischen den beiden Zonen P1 und P2. Der ohmsche Baslsanschluß ist mit T1b bezeichnet und liegt in einem hochdotierten Bereich der Basiszone N1.

Der die erste Potentialquelle +V mit dem Emitter T1e verbindende Widerstand R1 ist außerhalb des Halbleiterplättchens verwirklicht, so daß sein Wert für den jeweiligen Anwendungsfall leicht veränderbar ist. Sieht man beispielsweise einen relative niederohmigen Widerstand R1 vor, so fließt ein höherer Strom, was eine Erhöhung der Schaltgeschwindigkeit und des Leitungsverbrauches mit sich bringt. Wird ein relative niedriger Leitungsverbrauch angestrebt, so ist ein hochohmiger Widerstand R1 vorzusehen. Dabei nimmt man in Kauf, daß die Schaltgeschwindigkeit herabgesetzt wird. Es ist darauf hinzuweisen, daß der Widerstand R1 selbstverständlich auch auf dem Halbleiterplättchen mitintegriert werden kann.

Bei der Herstellung der Halbleiteranordnung geht man in bekannter Weise von einem P-dotierten Halbleitersubstrat aus, auf dem eine N-Epitaxieschicht mit einer vergrabenen $N^+$-Subkollektorzone angeordnet ist. In der Struktur gemäß Fig. 2 sind die Zonen N1 and N6 Bereiche einer derartigen N-Epitaxieschicht auf einem P-Substrat. Die Zonen N1 und N6 sind durch $P^+$-Isolationszonen voneinander getrennt. Zur Herstellung der NPN-Transistoren T2, T3, T4 und T5 wird in die Zone N6 eine P-dotierte Zone P3 durch Diffusion oder Ionenimplantation eingebracht. Diese Zone P3 bildet die Basis der Transistoren T2, T3, T4 und T5. Der ohmsche Anschluß zu dieser Zone P3 ist mit T2b—T5b bezeichnet und bildet den Basisanschluß des Transistors T5. Dieser Basisanschluß ist mit dem Kollektor T1c des Transistors T1 und mit dem Eingangsknoten EING verbunden. In die Zone P3 sind $N^+$-dotierte Zone N2, N3, N4 und N5 eingebracht, die mit den entsprechenden ohmschen Anschlüssen die Emitter T2e, T3e, T4e und T5e bilden. Der Emitter T5e des Transistors T5 und die Basis T1b des Transistors T1 sind gemeinsam mit der zweiten Potentialquelle (Masse) verbunden. Die Emitter T2e, T3e und T4e bilden die Ausgänge der Grundschaltung. Die $P^+$-Isolationszone trennt die NPN-Transistoren von dem PNP-Transistor T1.

Die Zone N6 bildet den gemeinsamen Kollektor der Transistoren T2, T3, T4 und T5. Der gemeinsame Anschluß ist der mit T2c—T5c bezeichnete Kollektoranschluß. Ein geeignet gewählter Widerstand R2 verbindet die erste Potentialquelle +V mit diesem Kollektoranschluß. An dieser Stelle ist darauf hinzuweisen, daß die in Fig. 2 gezeigte Struktur lediglich ein Ausführungsbeispiel der Grundschaltung gemäß Fig. 1 darstellt. Beispielsweise kann der Widerstand R2 mitintegriert oder aber als externes Bauelement vorgesehen werden. In integrierter Form erscheint es angebracht, den Widerstand R2 als Schichtwiderstand der Zone N6 zwischen Kollektoranschluß T2c—T5c und der $N^+$-Subkollektorzone zu verwirklichen. Wird überhaupt kein Widerstand R2 benötigt, so erübrigt sich ein Kollektoranschluß zur ersten Potentialquelle +V.

Zur Herstellung einer erfindungsgemäßen Grundschaltung lassen sich in vorteilhafter Weise die Prozeßschritte einsetzen, die üblicherweise bei der Herstellung der integrierten Injektions-Logik (I²L) angewandt werden.

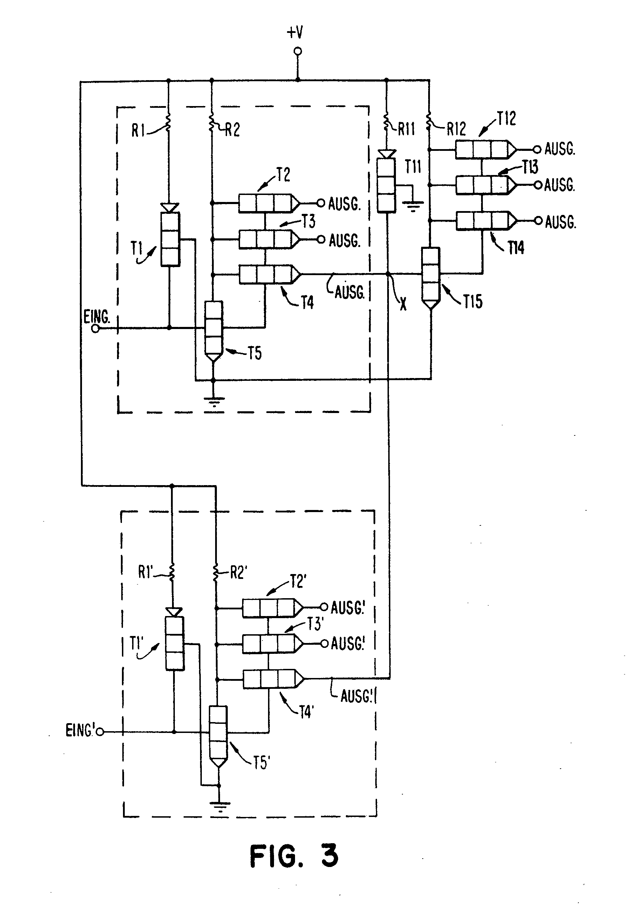

Es sei nun die in Fig. 3 dargestellte logische Schaltung näher betrachtet, die durch Verknüpfung von erfindungsgemäßen Grundschaltungen hergestellt ist. Verwirklicht ist beispielsweise eine unter dem Begriff "DOT-Logik" bekannte logische Schaltung. Zur Vereinfachung ist die erfindungsgemäße Schaltung gemäß Fig. 1 als Teil der logischen Schaltung durch gestrichelte Linien besonders hervorgehoben. Entsprechende Bauelemente sind dementsprechend mit denselben Bezugszeichen versehen. Lediglich die Bezeichnung der Emitter, der Basen und der Kollektoren der Transistoren wurde nicht wiederholt. In der logischen Schaltung gemäß Fig. 3 sind zwei erfindungsgemäße Grundschaltungen gemäß Fig. 1 verwendet, wobei die Bezugszeichen der einen mit einem Strichindex versehen sind. Die DOT-Funktion der gezeigten Schaltung ergibt sich am Knoten X, in dem die Ausgänge der Transistoren T4 und T4' direkt miteinander verbunden und an die Basis eines Transistors T15 geführt sind.

Als Beispiel ergibt folgende Wirkungsweise. Befindet sich das Signal am Eingangsknoten EING auf einem unteren logischen Pegel, so wird der vom Transistor T1 gelieferte Strom von der Basis des Transistors T5 abgeleitet, was bedeutet, daß dieser Transistor gesperrt wird. Ist Transistor T5 gesperrt, so sind die invers betriebenen Transistoren T2, T3 und T4 ebenfalls gesperrt. Wie anhand der Fign. 1 und 3 zu erkennen ist, wird bei gesperrtem Transistor T4 der vom Transistor T11 gelieferte Strom nicht abgeleitet, sondern der Basis des Transistors T15 zugeführt, der dadurch leitend wird. Mit in Sättigung leitendem Transistor T15 ergibt sich am Kollektor ein unterer logischer Pegel, während an den Basen der Transistoren T12, T13 und T14 ein oberer logischer Pegel entsteht. Das bedeutet, daß die Transistoren T12, T13 und T14 in inverser Richtung in Sättigung leitend werden und damit an den entsprechenden Ausgängen einen unteren logischen Pegel abgeben.

Liegt umgekehrt an der Basis des Transistors T5 ein oberer logischer Pegel an, so bringt der vom Transistor T1 gelieferte Strom den Transistor T5 in den leitenden Zustand. Mit in Sättigung leitendem Transistor T5 ergibt sich an seinem Kollektor (ebenso wie an den gemeinsamen Kollektoren der Transistoren T2, T3 und T4) ein unterer logischer Pegel. An den Basen der Transistoren T2, T3 und T4 liegt der obere logische Pegel, so daß diese Transistoren in inverser Richtung in Sättigung leitend sind. Die entsprechenden Ausgänge an den Emittern der Transistoren führen damit einen unteren logischen Pegel. Der vom Transistor T11 gelieferte Strom wird von der Basis des Transistors abgeleitet, so daß dieser gesperrt wird. Mit gesperrtem Transistor T15 sind auch die Transistoren T12, T13 und T14 gesperrt, über die dann vom Eingang einer nachfolgenden Stufe kein Strom abgeleitet werden kann.

Nimmt man eine Potentialdifferenz zwischen der ersten Potentialquelle +V und der zweiten Potentialquelle (Masse) in der Größenordnung von 1 V an, so beträgt der Spannungshub des über die logische Schaltung übertragenen Signals etwa 0,4 V. Wird in diesem Beispiel der mit der Basis des Transistors T5 verbundene Eingangsknoten EING auf den oberen logischen Pegel gebracht, so werden die Transistoren T2, T3 und T4 in inverser Richtung leitend, sobald der Transistor T5 die Sättigung erreicht hat. Bei leitendem Transistor T5 liegt an dessen Kollektor und damit auch an dem gemeinsamen anderen Kollektoren der untere logische Pegel, so daß, falls der wahlweise einsetzbare Widerstand R2 vorhanden ist, durch diesen Widerstand ein gewisser Strom fließt. Die dabei auftretende Verlustleistung wird in Kauf genommen, da der Widerstand R2 zur Aufladung der gemeinsamen Kollektoren von T2, T3, T4 und T5 auf den oberen logischen Pegel beiträgt, sobald der Transistor T5 gesperrt wird. Auf diese Weise erreicht man, daß die Transistoren T2, T3 und T4 schneller gesperrt werden. Ist der Widerstand R2 nicht vorgesehen, so werden, sobald am Eingang der untere logische Pegel auftritt, die Transistoren T2, T3, T4 und auch T5 gesperrt und bewirken ein potentialmäßiges Schwimmen des gemeinsamen Kollektors. Wird bei fehlendem Widerstand R2 der Eingangsknoten auf den oberen logischen Pegel gebracht, so wird Transistor T5 in Sättigung leitend und sein Kollektor nahezu auf Massepotential gebracht. Dadurch werden auch die Transistoren T2, T3 und T4 in Sättigung leitend und ziehen dadurch Strom vom Eingangsknoten einer nachfolgenden Stufe ab. In dieser Schaltphase ist also infolge Fehlens des Widerstandes R2 keine Veränderung der Eigenschaft der Schaltung festzustellen. Wird jedoch der Eingangsknoten auf den unteren logischen Pegel gebracht und damit der Transistor T5 gesperrt, so wird die Umschaltzeit für die Transistoren T2, T3 und T4 in den gesperrten Zustand verlängert. Mit Hilfe eines Widerstandes R2 wird also die Schaltcharakteristik der betrachteten logischen Schaltung während der einen Schaltphase, in der der Eingangknoten auf den unteren logischen Pegel gebracht wird, verbessert.

Wie bereits erwähnt, ist die erfindungsgemäße Grundschaltung hinsichtlich ihrer Charakteristik veränderbar, wenn ein externer Widerstand R1 vorgesehen wird. Dieser Widerstand R1 ist jedoch auch in bekannter Weise mit der Schaltung zu integrieren, beispielsweise in Form einer eingebrachten P-dotierten Zone. Die Funktion des Widerstandes R1 und des Transistors T1 besteht darin, Strom in die Basis des Transistors T5 zu injizieren. Diese Strominjektion kann auch durch den Widerstand alleine, also ohne den lateralen PNP-Transistor T1 bewirkt werden.

Ein wesentliches Merkmal der erfindungsgemäßen Grundschaltung ist die erhöhte Zuverlässigkeit, die sich aus einer Unempfindlichkeit gegenüber Kurzschlüsse bzw. Leckstromwege verursachenden Defekten ergibt. Diese Defekte sind insbesondere bei I$^2$L-Strukturen festzustellen, die invers betriebene Transistoren verwenden. Betrachtet man beispielsweise einen der Emitter T2e, T3e oder T4e, der bei inverser Betriebsweise zum Kollektor des betreffenden Transistors wird, so kann über die Basiszone hinweg ein Kurzschluß oder ein Leckstromweg auftreten. Bei der erfindungsgemäßen Schaltung hat ein derartiger Defekt in einem oder mehreren der Transistoren T2, T3 und T4 keinen Einfluß auf die Schaltungsfunktion. Es sei beispielsweise angenommen, daß über die Basiszone des Transistors T4 ein Leckstromweg auftritt. In diesem Falle würde bei leitendem Transistor T5 der Strom von der Basis des Transistors T15 weg abgeleitet. In entsprechender Weise würde bei gesperrtem Transistor T5 der Strom nicht von der Basis des Transistors T15 abgeleitet. Das bedeutet aber, das der beschriebene Effekt keine Folgen auf die Funktion der Schaltung hat. Ein ähnliches Ergebnis erhält man für den Fall, daß Transistor T2 und T3 und auch für den Fall, daß sämtliche drei Ausgangstransistoren gleichzeitig Defekte aufweisen.

Auch ein normal betriebener Transistor, also beispielsweise Transistor T5, kann mit den beschriebenen Defekten behaftet sein. Es sei also ein Kurzschluß über die Basis des Transistors T5 angenommen. Im Schaltzustand mit dem unteren logischen Pegel am Eingangsknoten werden dann die Transistoren T2, T3 und T4 gesperrt und damit darin gehindert, den Strom von der nachfolgenden Stufe abzuleiten. Im Schaltzustand mit dem oberen logischen Pegel am Eingangsknoten werden die Transistoren T2, T3 und T4 leitend und ziehen damit den Strom von der folgenden Stufe ab. Es ist also festzustellen, daß die erfindungsgemäße Schaltung auch durch entsprechende Defekte nicht beeinflußt wird, wenn diese im normal betriebenen Transistor T5 auftreten.

Für den Fall, daß ein entsprechender Defekt sowohl im Transistor T5 als auch in einem oder mehreren der Transistoren T2, T3 und T4 auftritt, ist eine Beeinträchtigung der Funktionsweise der erfindungsgemäßen Schaltung feststellbar. Handelt es sich bei den betrachteten Defekten um Kurzschlüsse, so wird auch die erfindungsgemäße Schaltung unbrauchbar. Handelt es sich jedoch bei den betrachteten Defekten um hochohmige Leckstromwege, so ist es möglich, daß der Unterschied zwischen dem Ein- und Auszustand der Serienschaltung von Transistor T5 und den anderen betroffenen Transistoren ausreichend ist, un an der nachfolgenden Stufe einen ausreichenden logischen Pegelhub zu bewirken. Tritt beispielsweise bei beiden Transistoren T4 und T5 ein Defekt auf und besteht dieser Defekt bei mindestens einem der beiden Transistoren nicht aus einem Kurzschluß, dann bestimmt die Stromdifferenz des von der Basis des Transistors T15 weggeleiteten Stromes während der beiden Schaltpegel am Eingangsknoten der Basis des Transistors T5, ob die Schaltung noch funktionsfähig ist. Es ist an dieser Stelle darauf hinzuweisen, daß es statistisch außerordentlich unwahrscheinlich ist, daß gleichzeitig der Transistor T5 und einer der Transistoren T2, T3 und T4 einen Defekt aufweisen.

Wie bereits erwähnt, führt die in Fig. 3 dargestellte logische Schaltung, die aus mehreren erfindungsgemäßen Grundschaltungen besteht, eine logische DOT-Funktion aus. In der gegenüber der Fig. 1 zusätzlich eingezeichneten Grundschaltung sind die Bezugs zeichen analoger Elemente mit einem Strich versehen. Die einzelnen Grundschaltungen arbeiten in der bereits beschriebenen Weise. Da der Ausgang beider Transistoren T4 und T4' im Knoten X direkt zusammengeführt ist, ist jeder dieser beiden Transistoren in der Lage, das Potential im Knoten X nahezu auf Massepotential abzusenken. Wird also entweder an dem einen oder dem anderen Eingangsknoten EING bzw. EING' der obere logische Pegel angelegt, so wird der entsprechende Transistor T5 bzw. T5' in Sättigung leitend. Der zugehörige Transistor T4 bzw. T4' zieht das Potential im Knoten X nahezu auf Massepotential. Solange an einem oder an beiden Eingangsknoten der obere logische Pegel anliegt, ist im Knoten X der untere logische Pegel vorhanden. Es muß an beiden Eingangsknoten der untere logische Pegel anliegen, um im Knoten X den oberen logischen Pegel zu erzeugen, der dann eine Strominjektion in die Basis des Transistors T15 bewirkt. Diese logische Funktion wird üblicherweise als NOR-Funktion bezeichnet.

**Patentansprüche**

1. Grundschaltung einer integrierten Transistorlogik mit einer einen an eine erste Potentialquelle (+V) angeschlossenen gemeinsamen Kollektor (N6), eine gemeinsame Basis (P3) und mehrere individuelle Emitter aufweisenden Transistorstruktur (T2, T3, T4, T5), die leitend ist, wenn ein von einem Injektor gelieferter Strom in die den Eingang der Grundschaltung bildende gemeinsame Basis (P6) injiziert wird, und die gesperrt ist, wenn dieser Strom in Abhängigkeit von der Größe eines Eingangssignals von der gemeinsamen Basis (P6) abgezweigt wird und mit mindestens einem zweiten, invers betriebenen Transistor (T2, T3, T4), dessen individueller Emitter ein Ausgang der Grundschaltung ist dadurch gekennzeichnet, daß die Transistorstruktur einen ersten normal betriebenen, mit seinem Emitter an eine zweite Potentialquelle (Masse) angeschlossenen Transistor (T5) umfaßt.

2. Grundschaltung nach Anspruch 1, dadurch gekennzeichnet, daß der Injektor aus einem zum ersten Transitor (T5) komplementären lateralen Transistor (T1) besteht.

3. Grundschaltung nach Anspruch 1, dadurch gekennzeichnet, daß der injektor aus einem die erste Potentialquelle (+V) mit der Basis des ersten Transistors (T5) verbindenden Widerstand besteht.

4. Grundschaltung nach Anspruch 2, dadurch gekennzeichnet, daß der Emitter des den Injektor bildenden lateralen Transistor (T1) an die erste Potentialquelle (+V) angeschlossen ist, daß die Basis dieses lateralen Transistors (T1) mit dem Emitter des ersten Transistors (T5) verbunden und an die zweite Potentialquelle (Masse) angeschlossen ist und daß der Kollektor des lateralen Transistors (T1) mit der Basis des ersten Transistors (T5) verbunden ist.

5. Grundschaltung nach Anspruch 4, dadurch gekennzeichnet, daß der Emitter des lateralen Transistors (T1) über einen ersten Widerstand (R1) an die erste Potentialquelle (+V) angeschlossen ist.

6. Grundschaltung nach Anspruch 5, dadurch gekennzeichnet, daß der erste Widerstand (R1) getrennt von der integrierten Schaltung angeordnet ist.

7. Grundschaltung nach Anspruch 5, dadurch gekennzeichnet, daß der erste Widerstand (R1) in die Schaltung integriert ist.

8. Grundschaltung nach den Ansprüchen 1 bis 7, dadurch gekennzeichnet, daß der gemeinsame Kollektor der Transistorstruktur über einen zweiten Widerstand (R2) mit der ersten Potentialquelle (+V) verbunden ist.

9. Grundschaltung nach Anspruch 8, dadurch gekennzeichnet, daß der zweite Widerstand (R2) in die Schaltung integriert ist.

10. Logische Schaltung unter Verwendung der Grundschaltung nach den Ansprüchen 1 bis 9, dadurch gekennzeichnet, daß die Ausgänge zweier Grundschaltungen miteinander verbunden und auf den Eingang einer weiteren Grundschaltung geführt sind (Fig. 3).

## Claims

1. A basic integrated transistor logic circuit with a transistor structure (T2, T3, T4, T5) having a common collector (N6) connected to a first potential source (+V), a common base (P3), and several individual emitters, which is conductive when a current supplied by an injector is injected into the common base (P6) forming the input of the basic circuit and which is blocked when this current as a function of the value of an input signal is steered away from the common base (P6), and with at least a second inversely operated transistor (T2, T3, T4), whose individual emitter is an output of the basic circuit, characterized in that the transistor structure comprises a first normally operated transistor (T5) having its emitter connected to a second potential source (ground).

2. The basic circuit according to claim 1, characterized in that the injector consists of a lateral transistor (T1) complementary to the first transistor (T5).

3. The basic circuit according to claim 1, characterized in that the injector consists of a resistor connecting the first potential source (+V) to the base of the first transistor (T5).

4. The basic circuit according to claim 2, characterized in that the emitter of the lateral transistor (T1) forming the injector is connected to the first potential source (+V), that the base of this lateral transistor (T1) is connected to the emitter of the first transistor (T5) and the second potential source (ground), and that the collector of the lateral transistor (T1) is connected to the base of the first transistor (T5).

5. The basic circuit according to claim 4, characterized in that the emitter of the lateral transistor (T1) is connected to the first potential source (+V) by a first resistor (R1).

6. The basic circuit according to claim 5, characterized in that the first resistor (R1) is provided separately from the integrated circuit.

7. The basic circuit according to claim 5, characterized in that the first resistor (R1) is integrated in the circuit.

8. The basic circuit according to claims 1 to 7, characterized in that the common collector of the transistor structure is connected to the first potential source (+V) by a second resistor (R2).

9. The basic circuit according to claim 8, characterized in that the second resistor (R2) is permanently integrated in the circuit.

10. A logic circuit utilizing the basic circuit according to claims 1 to 9, characterized in that the outputs of two basic circuits are connected to each other and to the input of a further basic circuit (Fig. 3).

## Revendications

1. Circuit de base d'une logique intégrée à transistor avec une structure de transistor (T2, T3, T4, T5), comportant un collecteur commun (N6) connecté à une première source de potentiel (+V), une base commune (P3), et plusieurs émetteurs individuels, ladite structure étant conductrice lorsqu'on injecte un courant fourni par un injecteur dans la base commune (P6) formant l'entrée du circuit de base, et étant bloquée lorsque ce courant est dévié de la base commune (P6) en fonction de la valeur d'un signal d'entrée, et avec au moins un second transistor (T2, T3, T4) en fonctionnement inverse dont l'émetteur individuel constitue une sortie du circuit de base, circuit de base caractérisé en ce que: la structure de transistor comprend un premier transistor (T5) en fonctionnement normal dont l'émetteur est connecté à une seconde source de potentiel (masse).

2. Circuit de base selon la revendication 1, caractérisé en ce que l'injecteur est constitué par un transistor latéral (T1) complémentaire au premier transistor (T5).

3. Circuit de base selon la revendication 1, caractérisé en ce que l'injecteur est constitué par une résistance connectant la première source de potentiel (+V) à la base du premier transistor (T5).

4. Circuit de base selon la revendication 2, caractérisé en ce que l'émetteur du transistor latéral (T1) formant l'injecteur est connecté à la première source de potentiel (+V), en ce que la base de ce transistor latéral (T1) est connectée à l'émetteur du premier transistor (T5) et à la seconde source de potentiel (masse), et en ce que le collecteur du transistor latéral (T1) est connecté à la base du premier transistor (T5).

5. Circuit de base selon la revendication 4, caractérisé en ce que l'émetteur du transistor latéral (T1) est connecté à la première source de potentiel (+V) à travers une première résistance (R1).

6. Circuit de base selon la revendication 5, caractérisé en ce que la première résistance (R1) est disposée de sorte à être séparée du circuit intégré.

7. Circuit de base selon la revendication 5, caractérisé en ce que la première résistance (R1) est intégrée dans le circuit.

8. Circuit de base selon les revendications 1 à 7, caractérisé en ce que le collecteur commun de la structure de transistors est connecté à la première source de potentiel (+V) à travers une seconde résistance (R2).

9. Circuit de base selon la revendication 8, caractérisé en ce que la seconde résistance (R2) est intégrée dans le circuit.

10. Circuit logique utilisant le circuit de base selon les revendications 1 à 9, caractérisé en ce que les sorties de deux circuits de base sont connectées ensemble et connectées à l'entrée d'un autre circuit de base (figure 3).

**FIG. 1**

**FIG. 2**

FIG. 3